(19) Europäisches Patentamt
European Patent Office
Office européen des brevets

(11) **EP 1 648 084 B1**

(12) **FASCICULE DE BREVET EUROPEEN**

(45) Date de publication et mention
de la délivrance du brevet:
**29.06.2011 Bulletin 2011/26**

(51) Int Cl.:
***H03D 7/14*** *(2006.01)*

(21) Numéro de dépôt: **05292115.2**

(22) Date de dépôt: **11.10.2005**

(54) **Mélangeur de signaux**

Mischerschaltung

Mixer Circuit

(84) Etats contractants désignés:
**DE FR GB IT**

(30) Priorité: **12.10.2004 FR 0410744**

(43) Date de publication de la demande:
**19.04.2006 Bulletin 2006/16**

(73) Titulaire: **STMicroelectronics SA**
**92120 Montrouge (FR)**

(72) Inventeurs:
• **Butaye, Benoît**
**38400 Saint Martin d'Herbes (FR)**
• **Garcia, Luc**
**38760 Saint Paul de Varces (FR)**

(74) Mandataire: **Verdure, Stéphane**
**Cabinet Plasseraud**
**52 rue de la Victoire**
**75440 Paris Cedex 09 (FR)**

(56) Documents cités:
**EP-A- 0 760 554     US-A1- 2002 047 940**

## Description

La présente invention s'intéresse particulièrement aux modulations numériques utilisées dans les téléphones portables. Toutefois ces modulations peuvent être utilisées dans d'autres dispositifs que des téléphones portables et de manière plus générale dans tout dispositif de modulation numérique qui utilise une modulation en constellation. L'invention se rapporte plus particulièrement à la constitution d'un mélangeur de signaux pour ces modulations numériques

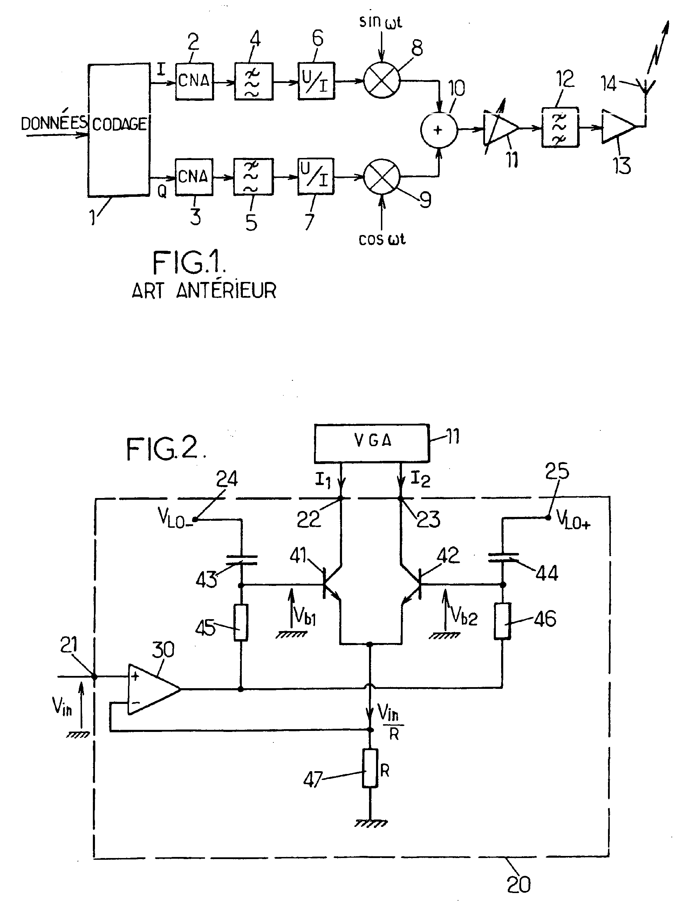

La figure 1 représente schématiquement une voie d'émission d'un téléphone portable. Les messages sont envoyés sous forme d'un train de données à un circuit de codage de modulation 1 qui transforme ce train de données en deux trains modulant I et Q représentatifs de la constellation. Deux convertisseurs numérique/analogique 2 et 3 transforment les signaux numériques I et Q en signaux analogiques. Deux filtres passe bas 4 et 5 filtrent les signaux provenant des convertisseurs analogiques 2 et 3 et les fournissent à des convertisseurs 6 et 7 tension/courant. Deux mélangeurs 8 et 9 mélangent chacun des signaux modulant représentatifs des trains I et Q à l'aide d'une porteuse haute fréquence. Chaque mélangeur 8 ou 9 reçoit la porteuse haute fréquence en quadrature, c'est-à-dire que le signal haute fréquence est déphasé d'un quart de période entre les mélangeurs 8 et 9. Un circuit d'addition 10 additionne ensuite les signaux provenant des mélangeurs 8 et 9 et les fournit à un amplificateur à gain variable 11. Un circuit de filtrage passe bande 12 élimine les images parasites créées par les mélangeurs 8 et 9 puis un amplificateur de puissance 13 amplifie le signal pour le fournir à une antenne 14.

Les téléphones portables ont comme contrainte particulière d'avoir les circuits les plus petits possibles pour une meilleure facilité d'intégration et également d'avoir une consommation réduite au maximum. A cet effet, une approche conventionnelle consistant à faire un découpage en circuit correspondant au découpage fonctionnel de la figure 1 nécessite d'une part une taille de circuit importante et d'autre part une consommation relativement élevée, chaque étage étant alimenté de manière indépendante. Afin de réduire l'encombrement et la consommation des circuits, il est connu de réaliser certains éléments fonctionnels de manière regroupée dans un même étage de circuit.

A titre d'exemple, la demande de brevet US n° 2003/0169090 dévoile un dispositif qui regroupe sur un même étage la fonction de mélangeur et la fonction d'amplificateur. Cependant, le circuit dévoilé par cette demande US nécessite des moyens de compensation relativement complexe à mettre en oeuvre.

Par ailleurs, la demande de brevet US n° 2002/0047940 dévoile un mélangeur comportant un amplificateur opérationnel ayant une paire de transistors formant un montage différentiel, et des moyens pour assurer l'immunité du facteur de modulation contre l'influence des variations de températures

Il existe toujours un besoin de circuit permettant une forte intégration et une faible consommation pour des chaînes de transmission numérique telles que représentées sur la figure 1.

L'invention propose une nouvelle solution basée sur un circuit mélangeur intégrant une conversion tension/courant dans le même étage.

L'invention est un dispositif mélangeur d'un système d'émission selon la revendication 1.

Selon un deuxième aspect, l'invention est un mélangeur différentiel comportant : une première borne d'entrée ; une deuxième borne d'entrée ; une première borne de sortie ; une deuxième borne de sortie ; un premier dispositif mélangeur ; et un deuxième dispositif mélangeur. La borne d'entrée de signal du premier dispositif mélangeur est reliée à la première borne d'entrée. La borne d'entrée de signal du deuxième dispositif mélangeur est reliée à la deuxième borne d'entrée. La première borne de sortie du premier dispositif mélangeur et la deuxième borne de sortie du deuxième dispositif mélangeur sont reliées à la première borne de sortie. La deuxième borne de sortie du premier dispositif mélangeur et la première borne de sortie du deuxième dispositif mélangeur sont reliées à la deuxième borne de sortie.

Selon un troisième aspect, l'invention est un mélangeur de signaux en quadrature qui comporte : une première paire d'entrées différentielles pour recevoir un premier signal modulant ; une deuxième paire d'entrées différentielles pour recevoir un deuxième signal modulant ; une paire de sorties différentielles ; un premier mélangeur différentiel, pour lequel les première et deuxième bornes d'entrée sont reliées à la première paire d'entrées différentielles, et les première et deuxième bornes de sortie sont reliées à la paire de sorties différentielles ; un deuxième mélangeur différentiel, pour lequel les première et deuxième bornes d'entrée sont reliées à la deuxième paire d'entrées différentielles, et les première et deuxième bornes de sortie sont reliées à la paire de sorties différentielles. Les signaux à haute fréquence du deuxième mélangeur différentiel sont en quadrature de phase par rapport aux signaux à haute fréquence du premier mélangeur différentiel.

Selon un autre aspect, l'invention est un système d'émission de données qui comporte : des moyens pour produire deux signaux modulant à partir d'un train de données, chaque signal modulant étant fourni de manière différentielle ; un mélangeur de signaux en quadrature, recevant sur chacune de ses paires d'entrées différentielles l'un des signaux modulant ; et des moyens d'amplification différentielle à gain variable reliés à la paire de sorties différentielles du mélangeur de signaux en quadrature.

L'invention sera mieux comprise et d'autres particularités et avantages apparaîtront à la lecture de la description qui va suivre, la description faisant référence aux figures annexées parmi lesquelles :

la figure 1 représente une chaîne d'émission numérique selon l'état de la technique,

la figure 2 représente de manière fonctionnelle un mélangeur selon l'invention,

la figure 3 illustre les courbes de fonctionnement du schéma de la figure 2,

la figure 4 montre un mélangeur différentiel basé sur le mélangeur de la figure 2 comportant en outre quelques améliorations,

la figure 5 illustre des courbes de fonctionnement du schéma de la figure 4, et

la figure 6 montre un exemple de mélangeur en quadrature intégrant la conversion tension/courant ainsi qu'un filtrage passe bas et une fonction d'amplification à gain variable dans un même étage.

La figure 2 représente un dispositif mélangeur 20 qui comporte une borne d'entrée 21 recevant un signal d'entrée $V_{in}$. Le dispositif mélangeur 20 comporte également deux bornes de sortie 22 et 23 qui sont des sorties différentielles fournissant un courant $I_1$ et $I_2$ respectivement. Deux autres bornes d'entrée 24 et 25 reçoivent deux signaux à haute fréquence qui correspondent au signal de porteuse. Les deux signaux à haute fréquence notés $V_{LO-}$ et $V_{LO+}$ correspondent à un même signal en opposition de phase.

Le dispositif mélangeur comporte un amplificateur 30, par exemple un amplificateur opérationnel ayant une entrée positive, une entrée négative et une sortie. L'entrée positive correspond à une entrée de signal et est reliée à la borne d'entrée 21. L'entrée négative correspond à une entrée de contre-réaction. Dans un premier temps, on considère qu'il s'agit d'un ampli opérationnel de type parfait.

Le dispositif mélangeur 20 comporte également une paire de transistors 41 et 42 formant un montage différentiel d'un type classique. Ce montage différentiel dispose de deux entrées différentielles de commande qui correspondent respectivement aux bases des transistors 41 et 42, une sortie commune de courant qui correspond aux émetteurs de la paire de transistors 41 et 42 ainsi que deux sorties différentielles de courant qui correspondent respectivement aux collecteurs des transistors 41 et 42. Les bases des transistors 41 et 42 sont reliées aux bornes d'entrée 24 et 25 par l'intermédiaire de condensateurs respectivement 43 et 44, et également à la sortie de l'amplificateur 30 par l'intermédiaire de résistances respectivement 45 et 46. Les émetteurs des transistors 41 et 42 correspondant à la sortie commune de courant du montage différentiel sont reliés à une résistance 47 qui fait office d'élément de conversion courant/tension. Cette résistance 47 est reliée à la masse par son autre borne. Et le noeud formé entre la sortie commune de courant et la résistance 47 est relié à l'entrée de contre réaction de l'amplificateur 30.

Les bornes de sortie 22 et 23 sont reliées à un amplificateur à gain variable 11.

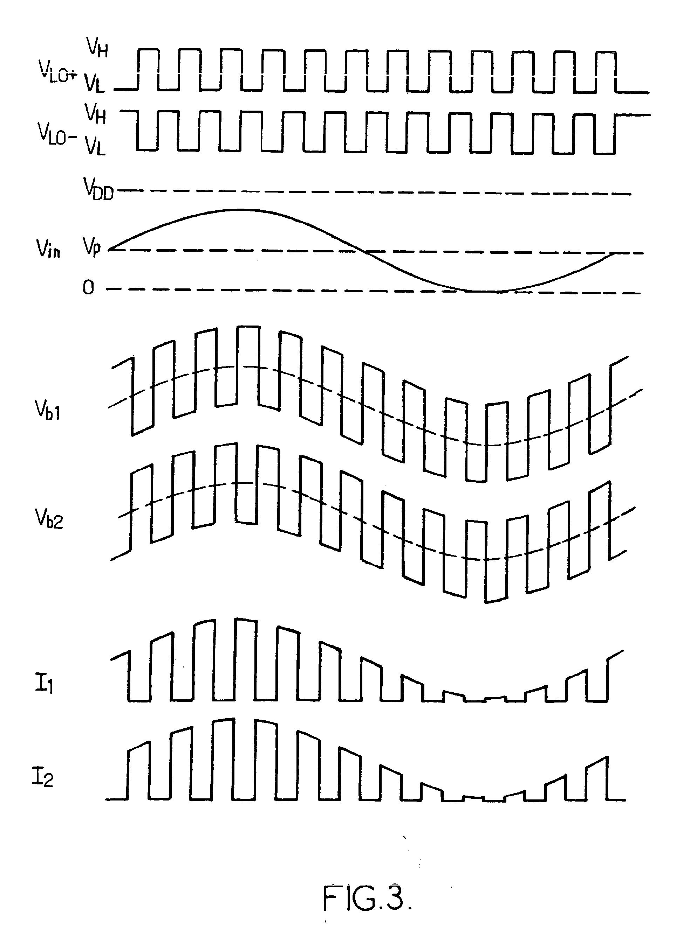

Le fonctionnement du circuit de la figure 2 va être à présent expliqué à l'aide des courbes représentées sur la figure 3. Les signaux haute fréquence $V_{LO-}$ et $V_{LO+}$ reçus par les bornes d'entrée 24 et 25 sont représentés sur la figure 3. Il s'agit d'un même signal en opposition de phase et à très haute fréquence. La fréquence du signal correspond par exemple à une fréquence porteuse de l'ordre de 900 Mhz. D'une manière purement théorique, le signal de porteuse devrait être une sinusoïde mais pour des raisons pratiques, on utilise un signal de forme carrée à rapport cyclique égal à un demi, c'est-à-dire que le signal de porteuse est égal à une tension haute $V_H$ pendant une demi période puis est égal à une tension basse $V_L$ pendant l'autre demi période. Pour expliquer le fonctionnement de cette figure 2, on considère que les signaux $V_{LO+}$ et $V_{LO-}$ sont des signaux carrés parfaits, c'est-à-dire avec des fronts montants et descendants dont la durée est nulle. Les signaux $V_{LO+}$ et $V_{LO-}$ sont montrés sur la figure 3 et sont compris tous les deux entre la tension basse $V_L$ et la tension haute $V_H$.

Le signal d'entrée $V_{in}$ correspond à un signal modulant. Ce signal d'entrée $V_{in}$ est représenté sur la figure 3, à titre d'exemple non limitatif, comme étant une sinusoïde basse fréquence par rapport à la fréquence des signaux $V_{LO+}$ et $V_{LO-}$. Pour des raisons pratiques, le rapport de fréquence entre le signal $V_{in}$ et les signaux $V_{LO+}$ et $V_{LO-}$ n'est pas respecté. Le signal $V_{in}$ est une sinusoïde additionnée à une composante continue Vp. L'amplificateur 30 amplifie le signal d'entrée $V_{in}$ et le fournit sur les bases des transistors 41 et 42 par l'intermédiaire des résistances 45 et 46. Par ailleurs, les condensateurs 43 et 44 sont dimensionnés de manière à se comporter en circuit ouvert vis à vis de la fréquence maximale du signal $V_{in}$, fréquence maximale qui est égale par exemple à quelques dizaines de Khz. Ces condensateurs 43 et 44 par contre se comportent comme des conducteurs vis à vis du signal haute fréquence correspondant aux signaux $V_{LO+}$ et $V_{LO-}$.

Ainsi les tensions de base $V_{b1}$ et $V_{b2}$ respectivement des transistors 41 et 42 correspondent à la somme de la tension de sortie de l'amplificateur 30 additionnée aux signaux respectifs $V_{LO+}$ et $V_{LO-}$ comme représenté sur la figure 3. Ainsi, lorsque le signal $V_{LO+}$ est égal à la tension haute $V_H$ et que le signal $V_{LO-}$ est égal à la tension basse $V_L$, le transistor 42 est passant et le transistor 41 est bloqué, le courant circulant dans le transistor 42 étant proportionnel à la tension $V_{in}$. Lorsque le signal $V_{LO+}$ est égal à la tension basse $V_L$ et que le signal $V_{LO-}$ est égal à la tension haute $V_H$,

3

le transistor 41 est passant et le transistor 42 est bloqué, le courant traversant le transistor 41 étant alors égal à un courant proportionnel à la tension $V_{in}$. La somme des courants 41 et 42 correspondant aux courant fournis par la sortie commune est donc proportionnelle à la tension $V_{in}$. Ce courant est fourni à la résistance 47 de valeur R et se trouve alors égal à la tension $V_{in}/R$ car l'amplificateur 30 est un amplificateur opérationnel considéré parfait, la tension sur son entrée + et la tension sur son entrée - étant considérées égales et aucun courant ne rentrant dans cet amplificateur. Un tel bouclage sur l'amplificateur permet de s'assurer d'avoir un courant égal à $V_{in}/R$ sur la sortie commune du montage différentiel. Comme il a été expliqué précédemment, les transistors 41 et 42 sont alternativement bloqués et passants, un seul des transistors étant passant en même temps, ce qui donne une forme de courant $I_1$ et $I_2$ comme représenté sur la figure 3 qui correspondant à un courant dont l'enveloppe est proportionnelle à $V_{in}$ multiplié par respectivement les signaux $V_{LO+}$ et $V_{LO-}$.

Si l'on soustrait les courants $I_1$ et $I_2$, on obtient un courant dont la forme correspond à un signal carré avec une enveloppe correspondant à $V_{in}$.

Si l'on considère que $V_{LO}+$ correspond à une porteuse logique que l'on appelle $P_{(t)}$ et qui peut prendre les niveaux logiques « 0 » ou « 1 » alors $V_{LO-}$ correspond à $1 - P_{(t)}$ ou encore à $\overline{P}_{(t)}$. L'expression du signal $V_{in}$ correspond à Vp + $S_{(t)}$, avec $V_p$ une tension continue et $S_{(t)}$ le signal modulant alors on obtient les formules suivantes :

$$I_1 = \frac{V_p + S_{(t)}}{R} \, P_{(t)}$$

$$I_2 = \frac{V_p + S_{(t)}}{R} \, (1 - P_{(t)})$$

Ainsi, si l'on effectue la différence $I_1 - I_2$ car les sorties de courant sont différentielles, on obtient l'expression suivante :

$$I_1 - I_2 = \frac{V_p + S_{(t)}}{R} \, (2P_{(t)} - 1)$$

La différence $I_1 - I_2$ correspond à la porteuse $2P_{(t)}-1$ modulée par le signal $S_{(t)}$ avec un facteur 2/R. La porteuse 2P(t) — 1 est de la même forme que la porteuse P(t) mais avec un niveau « 0 » égal à « -1 ».

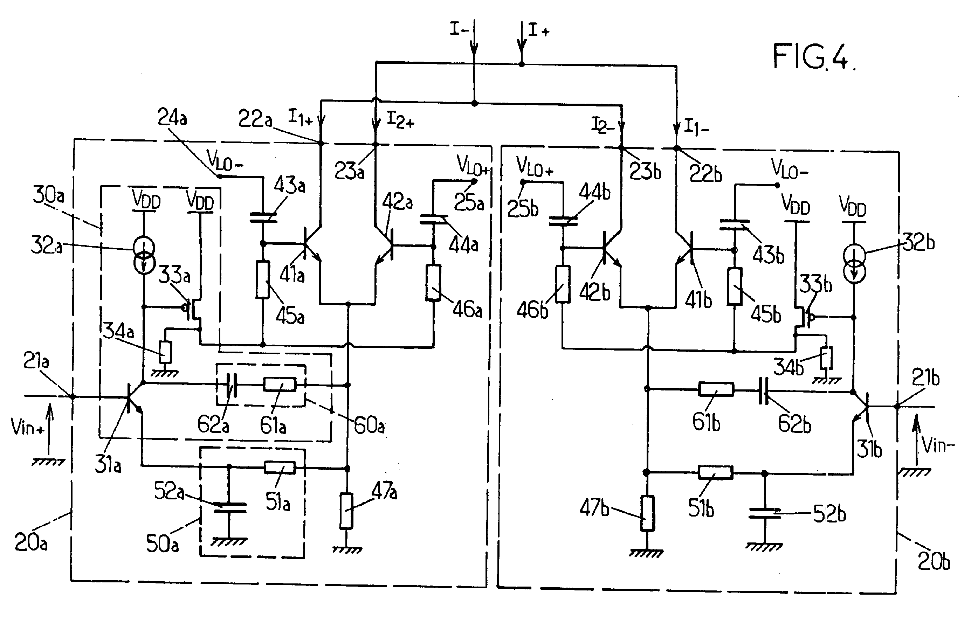

Le schéma de la figure 2 représente de manière fonctionnelle le dispositif mélangeur objet de l'invention. Cependant, pour expliquer son fonctionnement, il a été fait certaines hypothèses notamment que l'amplificateur 30 était un amplificateur opérationnel parfait et que la porteuse était un signal carré parfait. Pour la mise en oeuvre en circuits intégrés de ce dispositif, il convient de montrer à présent comment réaliser ce circuit en tenant compte de la réalité. Par ailleurs, ce circuit montre comment on module un signal en obtenant deux sorties différentielles de courant à partir d'un seul signal d'entrée. Pour les téléphones portables, afin de s'affranchir de certains problèmes de décalage de tension notamment au niveau de l'entrée $V_{in}$ ainsi que d'autres décalages de tension, il convient de travailler de manière différentielle. La figure 4 montre la réalisation d'un mélangeur différentiel basé sur le schéma du dispositif mélangeur de la figure 2, lequel a été détaillé pour un mode de réalisation particulier en circuit intégré.

Le mélangeur différentiel de la figure 4 comporte deux dispositifs mélangeurs 20a et 20b identiques. L'un reçoit sur sa borne d'entrée de signal 21 a la tension $V_{in+}$ et l'autre reçoit sur borne d'entrée de signal 21 b la tension $V_{in-}$. La tension $V_{in+}$ correspond par exemple à la tension $V_{in}$ du schéma de la figure 2 et c'est à dire une tension égale à Vp + $S_{(t)}$, où $S_{(t)}$ est le signal modulant. La tension $V_{in-}$ correspond à une tension égale à Vp - $S_{(t)}$, Vp étant une tension continue. Ainsi, la différence $V_{in+} - V_{in-}$ correspond à un signal égal à $2S_{(t)}$. Les bornes de sortie différentielles de courant sont connectées ensemble de manière inversée, c'est-à-dire que la borne correspondant à la tension de porteuse $V_{LO+}$ de l'un des circuits est connectée à la borne de sortie correspondant à la tension de porteuse $V_{LO-}$ et réciproquement.

Comme indiqué, les dispositifs mélangeur 20a et 20b sont identiques et correspondent tout deux au dispositif mélangeur de la figure 2. Cependant afin de les différencier, les indices a et b sont rajoutés aux numéros de référence. Ainsi un numéro de référence avec ou sans lettre d'indice correspond à un même élément. Pour simplifier la description, seuls les éléments rajoutés sur cette figure sont commentés. Egalement pour simplifier, les éléments sont détaillés pour le dispositif 20a uniquement mais correspondent aux mêmes éléments sur le dispositif 20b avec un indice b à la place de l'indice a.

L'amplificateur 30a doit être un amplificateur à faible bruit. Ainsi, il convient d'utiliser une forme d'amplificateur relativement simplifiée comportant un minimum de transistors. A titre d'exemple préféré, l'amplificateur est constitué d'un transistor bipolaire 31 a polarisé sur son collecteur par une source de courant 32a. La base du transistor 31 a correspond à l'entrée positive de l'amplificateur opérationnel 30a, l'émetteur du transistor 31 a correspond à l'entrée négative de l'amplificateur 30a. Le transistor 31 a et la source de courant 32a forment un étage d'entrée de l'amplificateur 30a. Le collecteur du transistor 31 a est relié à la grille d'un transistor 33a, et l'émetteur du transistor 31 a est relié au noeud formé par les émetteurs des transistors 41 a et 42a et de la résistance 47a par l'intermédiaire d'un filtre passe bas 50a. Le filtre passe bas 50a est par exemple composé d'une résistance 51 a et d'un condensateur 52a. L'amplificateur 30a comporte également un transistor PMOS 33a dont la source est reliée à la tension d'alimentation $V_{DD}$, la grille est reliée au collecteur du transistor 31 a, et dont le drain est relié à la masse par l'intermédiaire d'une résistance 34a de polarisation. Le noeud entre le drain du transistor 33a et la résistance 34a correspond à la sortie de l'amplificateur 30a et se trouve relié aux résistances 45a et 46a pour fournir aux bases des transistors 41 a et 42a le signal de sortie de l'amplificateur 30a. Le transistor 33a et la résistance 34a correspondent à un étage de sortie de l'amplificateur 30a. Un circuit de stabilisation 60a est connecté entre l'émetteur du transistor 31a et le noeud formé par les émetteurs des transistors 41 a et 42a et de la résistance 47a. Le circuit de stabilisation 60a est par exemple réalisé à l'aide d'une résistance 61 a et d'un condensateur 62a monté en série.

Le filtre passe bas 50a a été rajouté pour compenser le fait que le signal de porteuse n'est pas rigoureusement un signal carré mais comporte des fronts montants et descendants ayant une certaine pente. Lors de l'addition des courants d'émetteurs des transistors 41 a et 42a, les pentes du signal de porteuse se transforment en impulsions brèves qui s'additionnent au courant théorique devant traverser la résistance 47a. La résistance 51a est dimensionnée pour la tension à ses bornes soit négligeable par rapport à la tension aux bornes de la résistance 47a et le condensateur 52a est dimensionné pour se comporter en court circuit à des fréquences supérieures à la fréquence du signal $S_{(t)}$ afin de se comporter en court-circuit pour les fréquence harmonique de la fréquence du signal P(t). L'ajout du filtre 50a a comme inconvénient de transformer l'amplificateur 30a en amplificateur de haute fréquence. En effet, celui ci atténuant fortement les hautes fréquences sur la boucle de contre réaction, l'ensemble constitué du filtre 30a et du filtre 50a a pour effet d'amplifier fortement les signaux haute fréquence, par exemple des parasites, pouvant intervenir en entrée. Afin de compenser une amplification de parasites haute fréquence arrivant sur la borne d'entrée, l'amplificateur 30a est muni d'un circuit de stabilisation 60a qui sert à limiter la bande passante globale de l'amplificateur 30a.

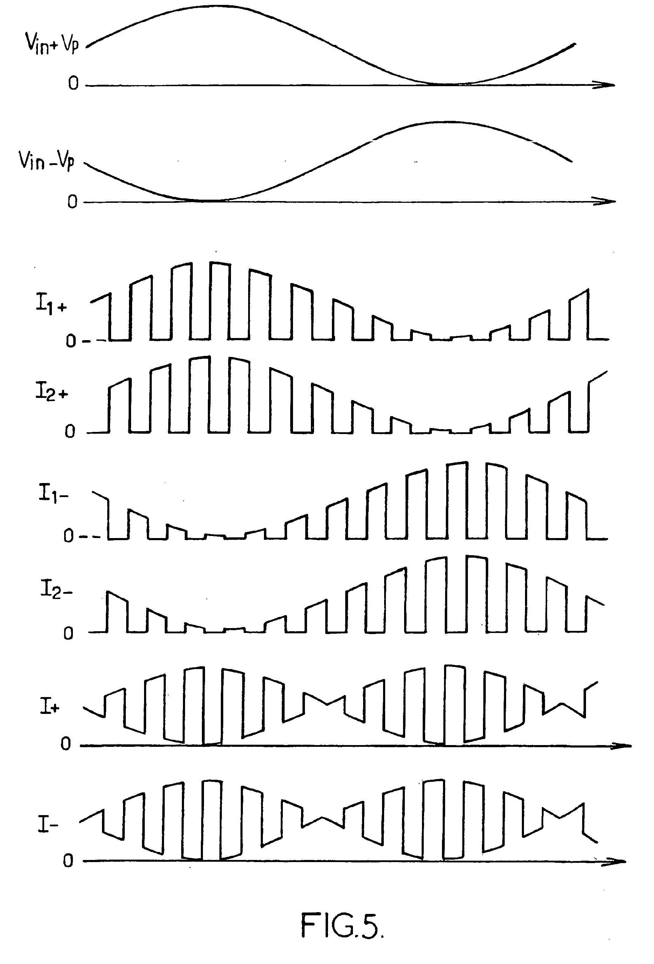

Le fonctionnement de chaque dispositif mélangeur 20a de la figure 4 est globalement le même que celui de la figure 2. Les seules différences de fonctionnement intervenant dans le fonctionnement interne du circuit, ceux-ci n'ont aucune répercussion sur le fonctionnement vu de l'extérieur de ce circuit. A l'aide de la figure 5, on va à présent décrire le fonctionnement global du circuit du mélangeur différentiel représenté sur la figure 4.

L'un des dispositifs mélangeurs reçoit la tension $V_{in+}$ et l'autre dispositif mélangeur reçoit la tension $V_{in-}$. Les tensions $V_{in+}$ et $V_{in-}$ correspondent à un même signal modulant $S_{(t)}$, lequel est pour la tension $V_{in+}$ additionné à une tension continue Vp et pour la tension $V_{in-}$, ce signal $S_{(t)}$ est inversé et additionné à la tension Vp. Le circuit recevant la tension $V_{in+}$ fournit les courant $I_1 - I_2$ correspondant au courant précédemment décrit à l'aide de la figure 3. Le dispositif mélangeur recevant la tension $V_{in-}$ fournit les courants respectifs $I_{1-}$ et $I_{2-}$ correspondant à la tension $V_{in-}$ modulée d'une part par le signal $V_{LO+}$ et d'autre part par le signal $V_{LO-}$. Les bornes de sorties différentielles des deux dispositifs mélangeurs 20 étant connectées ensemble de manière inversée, les courants différentiels résultant $I_-$ et $I_+$ correspondent respectivement au courant $I_{1+}$ additionné du courant $I_{2-}$ et au courant $I_{2+}$ additionné du courant $I_{1-}$. Les courants $I_+$ et $I_-$ sont représentés sur la figure 5 et correspondent respectivement à la somme des courants indiqués. Si l'on effectue la différence des courants $I_+$ et $I_-$, on obtient un courant proportionnel à $I_+$ pour la partie variable, la partie continue étant ramenée à zéro. On obtient alors un courant dont la forme correspond à un signal carré centré autour de zéro ayant une enveloppe correspondant au signal $S_{(t)}$. Ainsi, à partir des formules $V_{in-}$ et $V_{in+}$ ci-dessous :

$$V_{in+} = V_p + S_{(t)}$$

$$V_{in-} = V_p - S_{(t)}$$

On obtient alors les courants sortants $I_{1+}$, $I_{2+}$, $I_{1-}$ et $I_{2-}$ suivants :

$$I_{1+} = \frac{V_p + S_{(t)}}{R} P_{(t)}$$

$$I_{2+} = \frac{V_p + S_{(t)}}{R} (1 - P_{(t)})$$

$$I_{1-} = \frac{V_p - S_{(t)}}{R} P_{(t)}$$

$$I_{2-} = \frac{V_p - S_{(t)}}{R} (1 - P_{(t)})$$

Puis le couplage des deux dispositifs mélangeurs produit les signaux I$_+$ et I- suivants :

$$I_+ = I_{2+} + I_{1-} = \frac{1}{R} (V_p + S_{(t)} - 2 S_{(t)} P_{(t)})$$

$$I_- = I_{1+} + I_{2-} = \frac{1}{R} (V_p - S_{(t)} + 2 S_{(t)} P_{(t)})$$

Ainsi, si l'on effectue la différence I$_+$ - I- car les sorties sont différentielles et que le courant doit être considéré de manière différentielle, on obtient l'expression suivante :

$$I_+ - I_- = 2 \frac{S_{(t)}}{R} (1 - 2P_{(t)})$$

Il est à noter que la partie égale 1 — 2P$_{(t)}$ correspond en fait à une porteuse correspondant à un signal carré de même fréquence que la porteuse logique P$_{(t)}$ mais dont l'amplitude varie entre -1 et 1.

La figure 4 montre un exemple d'intégration du mélangeur différentiel de la figure 4 dans la chaîne d'émission représenté sur la figure 1 en intégrant dans un même étage, d'une part les filtres 4 et 5 mais également les circuits de conversion tension/courant 6 et 7, les mélangeurs 8 et 9 ainsi que l'additionneur 10 et l'ampli à gain variable 11.

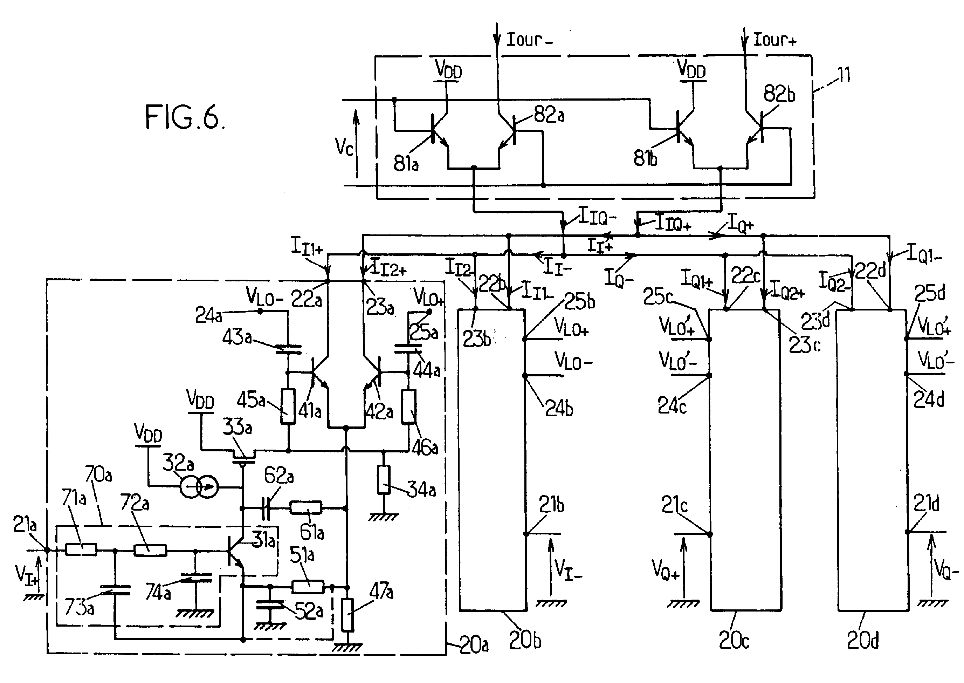

Quatre dispositifs mélangeurs 20a, 20b, 20c, 20d sont représentés sur la figure 6. Chacun de ces mélangeurs 20a à 20d sont identiques pour des raisons pratiques, qu'il a été seulement détaillé le dispositif mélangeur 20a. Le dispositif mélangeur 20a comporte toutes les caractéristiques des dispositifs mélangeurs 20 et 20a décrits précédemment mais intègrent en outre un filtre passe bas 70a qui correspond au filtre passe bas 4 ou 5 représenté sur la figure 1. Le filtre 70a est un filtre comportant deux résistances 71 a et 72a montées en série entre l'entrée de l'amplificateur c'est à dire la base du transistor 31 a et la borne d'entrée 21 a ainsi que deux condensateurs 73a et 74a. Le condensateur 73a relie le noeud entre les résistances 71 a et 72a à l'émetteur du transistor 31a. Le condensateur 74a est relié entre le noeud entre la résistance 72a et la base du transistor 31 a d'une part et d'autre part à la masse. Il est à noter que le condensateur 73a peut être relié à l'émetteur du transistor 31 a de manière indirecte en étant relié au noeud entre la résistance 47a et les émetteurs des transistors 41 a et 42a. Il est également à noter que le transistor 31 a correspond à un élément actif du filtre 70a en plus de faire partie de l'amplificateur 30a. Ce filtre 70a se comporte comme un filtre actif passe bas de second ordre et va supprimer les parasites liés au convertisseur numérique situés en amont. Le fonctionnement global du dispositif 20a est le même que les dispositifs 20 et 20a précédemment décrits en incluant le dispositif de filtrage 70a qui sert à obtenir en entrée un signal plus propre que le signal fournit par le convertisseur numérique/analogique.

Afin de réaliser un mélangeur différentiel en quadrature, les quatre dispositifs mélangeurs 20a à 20d diffèrent uniquement de part leur connexion extérieure. Le dispositif mélangeur 20a va recevoir sur son entrée une tension $V_{I+}$ qui correspond à un signal modulant correspondant au train I auquel on a additionné une tension continue. Le dispositif mélangeur 20b va recevoir une tension $V_{I-}$ qui correspond à l'inverse d'une tension représentative du signal I à laquelle on a ajouté une tension continue. Les dispositifs mélangeurs 20a et 20b reçoivent sur leurs bornes 24a et 24b un même signal $V_{LO-}$ et sur leurs bornes 25a et 25b le même signal et $V_{LO+}$. Les signaux $V_{LO-}$ et $V_{LO+}$ correspondent à un oscillateur comme précédemment décrit. Les sorties des dispositifs mélangeurs 20a et 20b sont reliées ensemble de manière inversée afin d'obtenir des courants de sortie $I_{I+}$ et $I_{I-}$ représentatifs du mélange différentiel des tensions d'entrée $V_{I+}$ et $V_{I-}$. Les courant $I_{I+}$ et $I_{I-}$ sont de la forme représentée sur la figure 5 et qui correspond au courant $I_+$ et $I_-$.

Le dispositif mélangeur 20c reçoit sur sa borne d'entrée 21 une tension $V_{Q+}$ qui correspond au signal modulant représentatif du train Q additionné d'une tension continue. Le dispositif mélangeur 20d reçoit sur sa borne d'entrée 21 une tension $V_{Q-}$ qui correspond à l'inverse du signal modulant représentatif du train Q additionné d'une tension continue. Les bornes d'entrée 24a et 24b reçoivent un même signal $V'_{LO-}$ et Les bornes 25a et 25b reçoivent $V'_{LO+}$. Ces tensions $V'_{LO-}$ et $V'_{LO+}$ correspondent à une porteuse de même fréquence et de même nature que les signaux $V_{LO-}$ et $V_{LO+}$ mais déphasées d'un quart de période. Les sorties des dispositifs mélangeurs 20c et 20d sont reliées ensemble de manière inversée afin d'obtenir des signaux $I_{Q+}$ et $I_{Q-}$ de même nature que les signaux $I_{I+}$ et $I_{I-}$ mais avec une fréquence porteuse déphasée d'un quart de période.

Les conducteurs transportant les signaux $I_{1+}$ et $I_{Q+}$ sont reliés ensemble afin de fournir un courant $I_{IQ+}$ égal à la somme des courants $I_{I+}$ et $I_{Q+}$. Les conducteurs transportant les signaux $I_{I-}$ et $I_{Q-}$ sont reliés ensemble afin de fournir sur un courant $I_{IQ-}$ égal à la somme du courant $I_{I-}$ et du courant $I_{Q-}$. Les courant $I_{IQ-}$ et $I_{IQ+}$ sont fournis à l'amplificateur à gain variable 11.

L'amplificateur à gain variable 11 est d'un type classique il comporte par exemple deux paires de transistor à montage différentiel. Un transistor 81a et 82a formant la première paire un transistor 81 b et un transistor 82b formant la deuxième paire. Pour chacune des paires, les deux transistors ont leurs émetteurs reliés ensemble pour recevoir respectivement les courants $I_{IQ+}$ et $I_{IQ-}$. Le collecteur des transistors 81a et 81 b reçoit la tension d'alimentation $V_{DD}$ ou une tension de batterie $V_{bat}$, si une tension de batterie $V_{bat}$ supérieure à $V_{DD}$ est disponible dans le circuit intégré intégrant ce circuit. Le collecteur des transistors 82a et 82b correspond à une sortie de courant amplifiée respectivement $I_{out-}$ et $I_{out+}$. Les bases des paires de transistors 81 et 82 reçoivent une tension différentielle $V_C$ par exemple entre la base du transistor 81 a et la base du transistor 82a mais également entre la base du transistor 81 b et la base du transistor 82b. Cette tension $V_C$ est représentative d'un coefficient d'atténuation à appliquer à l'amplificateur à gain variable. Ce montage étant un montage connu. Il n'est pas nécessaire de le décrire plus en détail.

Un tel circuit tel que représenté sur la figure 6, permet d'intégrer les fonctions des filtres 4 et 5 des convertisseurs tension courant 6 et 7, des mélangeurs 8 et 9 du circuit d'addition 10 et de l'amplificateur à gain variable 11 dans un même étage de circuit. En effet, on s'aperçoit que la polarisation de cet étage s'effectue à l'aide de la source de courant 32, de la résistance 34, de la résistance 47 et de la tension continue Vp des signaux d'entrées. De plus seul le courant traversant la résistance 47 est important et l'amplificateur à gain variable 11 bénéficie de ce même courant de polarisation pour réaliser l'amplification d'où une consommation globale moins importante que si les étages étaient séparés. Le filtre 70 réalisant les fonctions de filtrage des filtres 4 et 5 correspond à l'ajout d'un filtre passif rendu actif par l'amplificateur 30 sans nécessiter de consommation supplémentaire.

De nombreuses variantes de l'invention sont possibles. Notamment, la présente description fait référence à des transistors de type MOS et bipolaires. L'homme du métier comprendra qu'il peut utiliser uniquement des transistor d'un seul type ou un mélange des deux types sans que cela implique de modification sur la structure fonctionnelle décrite.

## Revendications

**1.** Dispositif mélangeur (20) d'un système d'émission comportant

- une borne d'entrée de signal (21) pour recevoir une tension représentative d'un signal modulant S(t),
- deux bornes d'entrées différentielles (24, 25) recevant deux signaux à haute fréquence ($V_{LO+}$ et $V_{LO-}$) en opposition de phase l'un par rapport à l'autre,
- des première et deuxième bornes de sorties (22, 23) pour fournir deux courants ($I_1$ et $I_2$) représentatifs des signaux à haute fréquence modulés par le signal modulant,
- une paire de transistors (41, 42) formant un montage différentiel ayant deux entrées différentielles de commande reliée chacune à l'une des bornes d'entrées différentielles, deux sorties différentielles de courant reliées respectivement aux bornes de sortie et une sortie commune de courant dont le courant est égal à la somme des courants des sorties différentielle,

- un élément de conversion courant/tension (47) connecté entre la sortie commune de la paire de transistors et la masse, et apte à transformer le courant fournit par cette sortie en une tension,
- un amplificateur (30) disposant d'une entrée de signal, d'une entrée de contre réaction, et d'une sortie, apte à fournir en sortie un signal amplifié représentatif du signal présent sur l'entrée de signal, l'entrée de signal étant reliée à la borne d'entrée de signal, l'entrée de contre réaction étant reliée à la sortie commune de courant de la paire de transistors, et la sortie étant reliée à chacune des entrées différentielles de commande de la paire de transistors.

2. Dispositif mélangeur selon la revendication 1, lequel comporte un filtre passe-bas (50a) entre l'élément de conversion courant/tension et l'entrée de contre réaction de l'amplificateur.

3. Dispositif mélangeur selon l'une des revendications 1 ou 2, dans lequel l'amplificateur (30a) comporte un étage d'entrée (31 a, 32a) suivi d'un étage de sortie (33a), et dans lequel le dispositif mélangeur comporte un circuit de compensation (60a) reliant un noeud entre l'étage d'entrée et l'étage de sortie avec la sortie commune de la paire de transistors.

4. Dispositif mélangeur selon l'une des revendications 1 à 3, lequel comporte un filtre passe bas (70a) entre la borne d'entrée (21 a) et l'entrée de signal de l'amplificateur (30a).

5. Mélangeur différentiel comportant :

- une première borne d'entrée (21 a),
- une deuxième borne d'entrée (21 b),
- une première borne de sortie,
- une deuxième borne de sortie,
- **caractérisé en ce qu'**il comporte :
- un premier dispositif mélangeur (20a) selon l'une des revendications 1 à 4,
- un deuxième dispositif mélangeur (20b) selon l'une des revendications 1 à 4,

dans lequel :

- la borne d'entrée de signal (21a) du premier dispositif mélangeur (20a) est reliée à la première borne d'entrée,
- la borne d'entrée de signal (21 b) du deuxième dispositif mélangeur (20b) est reliée à la deuxième borne d'entrée,
- la première borne de sortie (22a) du premier dispositif mélangeur (20a) et la deuxième borne de sortie (23b) du deuxième dispositif mélangeur (20b) sont reliées à la première borne de sortie, et
- la deuxième borne de sortie (23a) du premier dispositif mélangeur (20a) et la première borne de sortie (22b) du deuxième dispositif mélangeur (20b) sont reliées à la deuxième borne de sortie.

6. Mélangeur de signaux en quadrature qui comporte :

- une première paire d'entrées différentielles (21 a, 21 b) pour recevoir un premier signal modulant,
- une deuxième paire d'entrées différentielles (21c, 21d) pour recevoir un deuxième signal modulant,
- une paire de sorties différentielles,
- **caractérisé en ce qu'**il comporte
- un premier mélangeur différentiel selon la revendication 5, pour lequel les première et deuxième bornes d'entrée sont reliées à la première paire d'entrées différentielles, et les première et deuxième bornes de sortie sont reliées à la paire de sorties différentielles,
- un deuxième mélangeur différentiel selon la revendication 5, pour lequel les première et deuxième bornes d'entrée sont reliées à la deuxième paire d'entrées différentielles, et les première et deuxième bornes de sortie sont reliées à la paire de sorties différentielles,

et dans lequel les signaux à haute fréquence du deuxième mélangeur différentiel sont en quadrature de phase par rapport aux signaux à haute fréquence du premier mélangeur différentiel.

7. Système d'émission de données qui comporte :

- des moyens pour produire deux signaux modulant (I, Q) à partir d'un train de données, chaque signal modulant étant fourni de manière différentielle,
- un mélangeur de signaux en quadrature selon la revendication 6, recevant sur chacune de ses paires d'entrées différentielles l'un des signaux modulant, et
- des moyens d'amplification différentielle à gain variable (11) reliés à la paire de sorties différentielles du mélangeur de signaux en quadrature.

**Claims**

1.  Mixer device (20) for a transmission system comprising

    - a signal input terminal (21) for receiving a voltage that is representative of a modulating signal S(t),
    - two differential input terminals (24, 25) receiving two high-frequency signals ($V_{LO+}$ and $V_{LO-}$) in phase opposition relative to one another,
    - first and second output terminals (22, 23) for delivering two currents ($I_1$ and $I_2$) that are representative of the high-frequency signals modulated by the modulating signal,
    - a pair of transistors (41, 42) forming a differential circuit having two differential control inputs each connected to one of the differential input terminals, two differential current outputs respectively connected to the output terminals and a common current output whose current is equal to the sum of the differential output currents,
    - a current/voltage conversion element (47) connected between the common output of the pair of transistors and the ground, and capable of transforming the current delivered by this output into a voltage,
    - an amplifier (30) having a signal input, a negative-feedback input and an output, capable of delivering at its output an amplified signal that is representative of the signal present at the signal input, the signal input being connected to the signal input terminal, the negative-feedback input being connected to the common current output of the pair of transistors, and the output being connected to each of the differential control inputs of the pair of transistors.

2.  Mixer device according to Claim 1, that comprises a low-pass filter (50a) between the current/voltage conversion element and the negative-feedback input of the amplifier.

3.  Mixer device according to either of Claims 1 and 2, in which the amplifier (30a) comprises an input stage (31a, 32a) followed by an output stage (33a), and in which the mixer device comprises a compensation circuit (60a) linking a node between the input stage and the output stage with the common output of the pair of transistors.

4.  Mixer device according to one of Claims 1 to 3, that comprises a low-pass filter (70a) between the input terminal (21a) and the signal input of the amplifier (30a).

5.  Differential mixer comprising:

    - a first input terminal (21a),
    - a second input terminal (21b),
    - a first output terminal,
    - a second output terminal,

    **characterized in that** it comprises:

    - a first mixer device (20a) according to one of Claims 1 to 4,
    - a second mixer device (20b) according to one of Claims 1 to 4,

    in which:

    - the signal input terminal (21a) of the first mixer device (20a) is connected to the first input terminal,
    - the signal input terminal (21b) of the second mixer device (20b) is connected to the second input terminal,
    - the first output terminal (22a) of the first mixer device (20a) and the second output terminal (23b) of the second mixer device (20b) are connected to the first output terminal, and
    - the second output terminal (23a) of the first mixer device (20a) and the first output terminal (22b) of the second mixer device (20b) are connected to the second output terminal.

6. Quadrature signal mixer that comprises:

- a first differential input pair (21a, 21b) for receiving a first modulating signal,
- a second differential input pair (21c, 21d) for receiving a second modulating signal,
- a pair of differential outputs,
**characterized in that** it comprises
- a first differential mixer according to Claim 5, for which the first and second input terminals are connected to the first pair of differential inputs, and the first and second output terminals are connected to the pair of differential outputs,
- a second differential mixer according to Claim 5, for which the first and second input terminals are connected to the second pair of differential inputs, and the first and second output terminals are connected to the pair of differential outputs,

and in which the high-frequency signals of the second differential mixer are in phase quadrature with respect to the high-frequency signals of the first differential mixer.

7. Data transmission system that comprises:

- means for producing two modulating signals (I, Q) from a data stream, each modulating signal being delivered in differential mode,
- a quadrature signal mixer according to Claim 6, receiving one of the modulating signals at each of its pairs of differential inputs, and
- means for variable-gain differential amplification (11) connected to the pair of differential outputs of the quadrature signal mixer.

## Patentansprüche

1. Mischvorrichtung (20) eines Ausgabesystems, umfassend

- eine Signaleingangsklemme (21) zum Empfang einer repräsentativen Spannung eines modulierenden Signals ($V_{in}$),
- zwei Differentialeingangsklemmen (24, 25), die zwei Hochfrequenzsignale ($V_{LO+}$ und $V_{LO-}$) in entgegengesetzter Phase zueinander empfangen,
- erste und zweite Ausgangsklemmen (22, 23) zur Bereitstellung von zwei repräsentativen Strömen ($I_1$ und $I_2$) der von dem modulierenden Signal modulierten Hochfrequenzsignale,
- ein Transistorpaar (41, 42), das eine Differentialmontage bildet mit zwei Differential-Steuereingängen, die jeweils mit einer der Differential-Eingangsklemmen verbunden sind, zwei Differential-Stromausgängen, die jeweils mit den Ausgangsklemmen verbunden sind und einem gemeinsamen Stromausgang, dessen Strom gleich der Summe der Ströme der Differentialausgänge ist,
- ein Strom/Spannungs-Umwandlungselement (47), das zwischen dem gemeinsamen Ausgang des Transistorpaars und der Masse geschaltet ist und in der Lage, den von diesem Ausgang bereitgestellten Strom in eine Spannung umzuwandeln,
- einen Verstärker (30), der über einen Signaleingang, einen Gegenreaktionseingang, und einen Ausgang verfügt, der in der Lage ist, am Ausgang ein verstärktes Signal bereitzustellen, das für das am Signaleingang vorhandene Signal repräsentativ ist, wobei der Signaleingang mit der Signaleingangsklemme verbunden ist, wobei der Gegenreaktionseingang mit dem gemeinsamen Stromausgang des Transistorpaars verbunden ist und der Ausgang mit jedem Differential-Steuereingang des Transistorpaars verbunden ist.

2. Mischvorrichtung nach Anspruch 1, wobei diese einen Tiefpassfilter (50a) zwischen dem Strom/Spannungs-Umwandlungselement und dem Gegenreaktionseingang des Verstärkers umfasst.

3. Mischvorrichtung nach einem der Ansprüche 1 oder 2, wobei der Verstärker (30a) eine Eingangsstufe (31a, 32a) umfasst, gefolgt von einer Ausgangsstufe (33a), und wobei die Mischvorrichtung einen Kompensationskreis (60a) umfasst, der einen Knoten zwischen der Eingangsstufe und der Ausgangsstufe mit dem gemeinsamen Ausgang des Transistorpaars verbindet.

4. Mischvorrichtung nach einem der Ansprüche 1 bis 3, wobei diese einen Tiefpassfilter (70a) zwischen der Eingangsklemme (21a) und dem Eingang des Verstärkersignals (30a) umfasst.

5. Differentialmischer, umfassend:

- eine erste Eingangsklemme (21 a),
- eine zweite Eingangsklemme (21 b),
- eine erste Ausgangsklemme,
- eine zweite Ausgangsklemme,

**dadurch gekennzeichnet, dass** er aufweist:

- eine erste Mischvorrichtung (20a) nach einem der Ansprüche 1 bis 4,
- eine zweite Mischvorrichtung (20b) nach einem der Ansprüche 1 bis 4, wobei:
- die Signaleingangsklemme (21a) der ersten Mischvorrichtung (20a) mit der ersten Eingangsklemme verbunden ist,
- die Signaleingangsklemme (21 b) der zweiten Mischvorrichtung (20b) mit der zweiten Eingangsklemme verbunden ist,
- die erste Ausgangsklemme (22a) der ersten Mischvorrichtung (20a) und die zweite Ausgangsklemme (23b) der zweiten Mischvorrichtung (20b) mit der ersten Ausgangsklemme verbunden sind, und
- die zweite Ausgangsklemme (23a) der ersten Mischvorrichtung (20a) und die erste Ausgangsklemme (22b) der zweiten Mischvorrichtung (20b) mit der zweiten Ausgangsklemme verbunden sind.

6. Signalphasenmischer, der umfasst:

- ein erstes Differential-Eingangspaar (21 a, 21 b) zum Empfang eines ersten modulierenden Signals,
- ein zweites Differential-Eingangspaar (21 c, 21 d) zum Empfang eines zweiten modulierenden Signals,
- ein Differential-Ausgangspaar,
**dadurch gekennzeichnet, dass** er umfasst
- einen ersten Differentialmischer nach Anspruch 5, wobei die erste und die zweite Eingangsklemme mit dem ersten Differential-Eingangspaar verbunden sind und die erste und die zweite Ausgangsklemme mit dem Differential-Ausgangspaar verbunden sind,
- einen zweiten Differentialmischer nach Anspruch 5, wobei die erste und die zweite Eingangsklemme mit dem zweiten Differential-Eingangspaar verbunden sind und die erste und die zweite Ausgangsklemme mit dem Differential-Ausgangspaar verbunden sind,

und wobei die Hochfrequenzsignale des zweiten Differentialmischers in Phasenverschiebung im Verhältnis zu den Hochfrequenzsignalen des ersten Differentialmischers sind.

7. Datenausgabesystem, das umfasst:

- Mittel, um zwei modulierende Signale (I, Q) aus einem Datenstrom herzustellen, wobei jedes modulierende Signal differential bereitgestellt wird,
- einen Signalphasenmischer nach Anspruch 6, der an jedem seiner Differential-Eingangspaare eines der modulierenden Signale empfängt, und
- Mittel zur Differentialverstärkung mit variabler Verstärkung (11), die mit dem Differential-Ausgangspaar des Signalphasenmischers verbunden sind.

FIG.1.
ART ANTÉRIEUR

FIG.2.

FIG.3.

FIG.4.

EP 1 648 084 B1

FIG.5.

FIG.6.

**EP 1 648 084 B1**

**Documents brevets cités dans la description**

- US 20030169090 A

- US 20020047940 A